## Europäisches Patentamt
## European Patent Office
## Office européen des brevets

(19)

(11) Numéro de publication: **0 166 634**
**B1**

(12)

# FASCICULE DE BREVET EUROPEEN

(45) Date de publication du fascicule du brevet: **03.10.90**

(51) Int. Cl.⁵: **H 01 L 23/48**

(21) Numéro de dépôt: **85400992.5**

(22) Date de dépôt: **21.05.85**

(54) **Dispositif de répartition de potentiel électrique, et boîtier de composant électronique incorporant un tel dispositif.**

(30) Priorité: **25.05.84 FR 8408247**

(43) Date de publication de la demande:
**02.01.86 Bulletin 86/01**

(45) Mention de la délivrance du brevet:
**03.10.90 Bulletin 90/40**

(84) Etats contractants désignés:
**DE GB IT NL SE**

(56) Documents cités:
**FR-A-2 496 341**
**FR-A-2 529 386**
**US-A-4 249 196**

**IEEE TRANSACTIONS ON COMPONENTS, HYBRIDS, AND MANUFACTURING TECHNOLOGY, vol. CHMT-6, no. 3, septembre 1983, pages 283-289, IEEE, New York, US; L.W. SCHAPER et al.: "Improved electrical performance required for future MOS packaging"**

(73) Titulaire: **THOMSON-CSF**
**51, Esplanade du Général de Gaulle**
**F-92800 Puteaux (FR)**

(72) Inventeur: **Val, Christian**
**THOMSON-CSF SCPI 173, bld Haussmann**
**F-75379 Paris Cedex 08 (FR)**

(74) Mandataire: **Benoit, Monique et al**
**THOMSON-CSF SCPI**
**F-92045 PARIS LA DEFENSE CEDEX 67 (FR)**

(56) References cited:
**PATENTS ABSTRACTS OF JAPAN, vol. 6, no. 205 (E-136) 1083r, 16 octobre 1982, page 115 E 136; & JP - A - 57 113 261 (NIPPON DENKI K.K.) 14-07-1982**

EP 0 166 634 B1

**Description**

La présente invention concerne les boîtiers de composants électroniques et elle a plus particulièrement pour objet un dispositif de répartition des potentiels électriques destinés à l'alimentation du composant, incorporé au boîtier.

Ainsi qu'il est connu, dans nombre de matériels modernes on cherche à miniaturiser les équipements électroniques. Cela est réalisé notamment par l'augmentation du degré d'intégration des circuits intégrés, ce qui se traduit en pratique à la fois par une augmentation de la complexité et du nombre du fonctions de chaque circuit intégré et par une diminution du nombre des composants. Toutefois, l'augmentation de la complexité d'un composant conduit à une augmentation du nombre de ses entrées et sorties et impose corrélativement un encombrement minimum au boîtier encapsulant le composant, que les boîtiers aient des pattes, ou broches de connexion, ou non (boîtier munis de plots de connexion, connus sous le nom de "CHIP CARRIER"), ce qui réduit d'autant les possibilités de miniaturisation.

Il est également connu de la demande de brevet FR 2,529,386 un boîtier pour composant électronique comportant un condensateur réalisé sur, sous ou dans le capot du boîtier.

La présente invention a pour objet un boîtier de composant électronique comportant un dispositif de répartition des potentiels électriques d'alimentation nécessaires à un composant (par exemple un ou plusieurs potentiels de valeur prédéfinie et un potentiel de référence, ou masse), ce dispositif étant destiné à être incorporé au boîtier encapsulant le composant. Le dispositif de répartition récoit ces potentiels d'alimentation de l'extérieur du boîtier et il est connecté en de multiples points au composant afin de distribuer les potentiels aux entrées/sorties appropriées du composant, permettant ainsi de réduire le nombre d'entrées/sorties du boîtier lui-même et par suite sa taille, pour un composant donné.

Plus précisément, l'invention a pour objet le boîtier de composant électronique comportant un dispositif de répartition de potentiel électrique tel que défini par la revendication 1.

D'autres objets, particularités et résultats de l'invention ressortiront de la description suivante, illustrée par les dessins annexés, qui représentent:

les figures 1, a et b, un premier mode de réalisation du dispositif de répartition dans lequel celui-ci forme le capot d'un boîtier;

la figure 2, un mode de disposition des plans conducteurs utilisés dans le dispositif;

les figures 3, a et b, un deuxième mode de réalisation du dispositif dans lequel celui-ci est placé à l'intérieur d'un boîtier;

les figures 4, a et b, des variantes de réalisation de l'insertion sur le dispositif d'un ou plusieurs condensateurs discrets;

les figures 5, a, b, et c, des variantes de réalisation de la connexion du dispositif au reste du boîtier.

Sur ces différentes figures, d'une part les mêmes références se rapportent aux mêmes éléments et, d'autre part, l'échelle réelle des différents éléments n'est pas respectée pour la clarté du dessin.

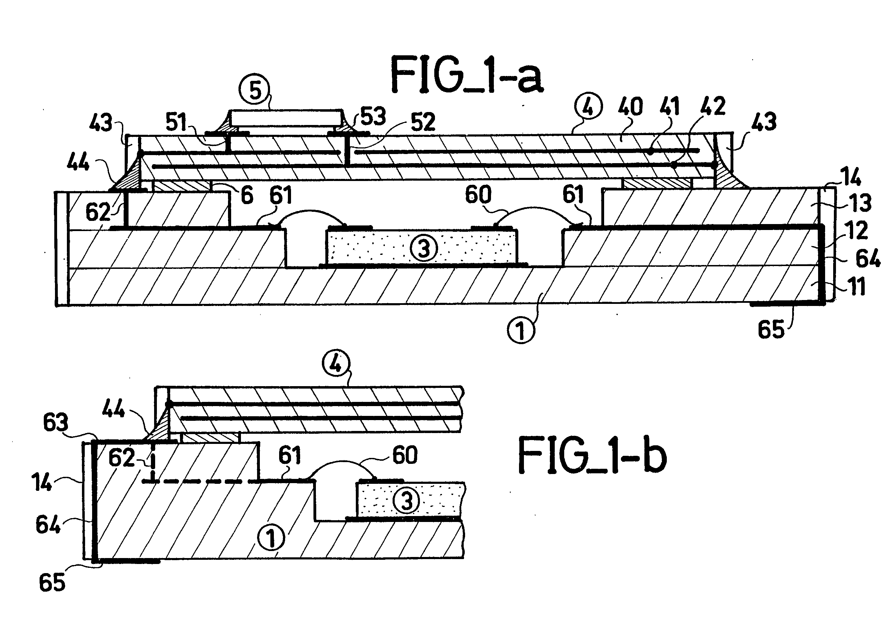

Sur la figure 1a, on a représenté un boîtier pour l'encapsulation, d'un composant 3, constitué par exemple d'un circuit électronique intégré réalisé sur une pastille de matériau semi-conducteur, par exemple de silicium. Il est à noter que l'on entend dans la présente description par "composant" tout composant passif ou actif, discret ou intégré, ainsi que tout circuit électronique (circuit hybride par exemple) susceptible d'être mis sous boîtier.

Le boîtier de la figure 1a se compose principalement d'une embase 1, portant le composant 3, et d'un capot constitué par le dispositif de répartition 4 selon l'invention. A titre d'exemple, on a représenté un boîtier du type "CHIP CARRIER".

L'embase 1 est réalisée en un matériau qui dont être habituellement rigide, de préférence isolant électrique et présentant certaines qualités thermiques telles qu'une bonne conduction thermique et un coefficient de dilatation aussi proche que possible de celui du composant 3. Elle est par exemple en plastique, en verre, en céramique etc...; dans le cas où le composant 3 est en silicium, l'embase peut être avantageusement en alumine. L'embase se compose, dans l'exemple représenté, de trois parties distinctes, repérées respectivement 11, 12 et 13. La première partie 11 est en forme de plaquette et supporte le composant 3; les deux autres parties sont constituées chacune d'un anneau, les anneaux étant concentriques et disposés l'un au-dessus de l'autre, autour du composant 3, avec un diamètre intérieur croissant, de façon à permettre les connexions électriques entre le composant, le répartiteur 4 et l'extérieur. Le composant 3 est donc fixé sur la face supérieure de la plaquette 11, par exemple par brasure sur une métallisation représentée en trait épais.

Les connexions sont réalisées de la façon suivante. Les points de connexion du composant 3 sont reliés chacun par des fils conducteurs tels que 60 à des pistes conductrices 61 disposées sur la partie supérieure de l'anneau 12 de l'embase 1. Ces pistes 61 sont connectées au reste du dispositif de trois façons différentes, selon la fonction qu'elles remplissent:

dans une première façon, illustrée à titre d'exemple sur la portie gauche de la figure 1a, la piste 61 aboutit à un puits conducteur 62, traversant l'anneau 13 de part en part et réalisant la connexion électrique entre la piste 61 et un plot de connexion 44 du dispositif de répartition 4; cette première façon correspond aux connexions entre le composant 3 et le dispositif de répartition 4, connexions qui ne sortent donc pas du boîtier;

dans une deuxième façon, illustrée à titre d'exemple sur la partie droite de la figure 1a, la piste 61 n'est pas reliée au dispositif de répartition 4 mais aboutit directement à un demi-trou 14, sensiblement en forme de demi-cyclindre réalisé dans l'épaisseur de l'embase 1 à sa périphérie, dans lequel une piste 64 relie la piste 61 à un plot de connexion 65 destinée à connecter le boîtier à l'extérieur; ce deuxième type de connexion est donc utilisé pour transmettre les signaux portant l'information (par opposition aux tensions d'alimentation) de l'extérieur vers le composant 3 et réciproquement;

la troisième façon est illustrée sur la figure 1b où on a représenté la fraction du boîtier intéréssée par les connexions; dans ces cas, c'est la connexion 44 du dispositif de répartition 4 qui est reliée au plot de connexion 65 du boîtier, par l'intermédiaire d'une piste 64 passant dans un demi-trou 14 et d'une piste 63 disposée sur la partie supérieure du disque 13 entre le puits 62 et le demi-trou 14; cette troisième façon correspond à la connexion du dispositif de répartition 4 à un potentiel d'alimentation extérieur. Dans une variante de réalisation représentée sur la figure 1b en pointillé, on peut au niveau d'une connexion du dispositif 4 vers l'extérieur (troisième façon) superposer une connexion du premier type entre le dispositif 4 et le composant 3.

Les pistes, et connexions 61 à 65 sont par exemple réalisées à base de métal réfractaire (tungstène par exemple).

A titre d'exemple, pour un composant d'environ 250 entrées/sorties, se décomposant en 190 entrées/sorties affectées aux signaux d'information et 60 entrées/sorties affectées à deux tensions d'alimentations et une masse, on a: 54 entrées/sorties du premier type, qui ne sortent pas du boîtier; 190 entrées/sorties signaux du deuxième type, et 6 entrées/sorties du troisième type, assurant à la fois l'alimentation, du dispositif 4 et celle, directement, du composant 3. Il apparaît ainsi de cet exemple numérique qu'à partir de 250 plots de connexion d'un composant, on obtient un boîtier de 196 connexions seulement.

Le dispositif de répartition 4 selon l'invention est constitué par on ou plusieurs plans conducteurs, selon le nombre de potentiels d'alimentation à distribuer au composant 3. Dans l'exemple des figures 1, on dispose deux plans repérés 41 et 42, séparés et entourés par un isolant 40 de façon à former une plaquette rigide, utilisée ici pour former le capot du boîtier. Dans le mode de réalisation représenté, la péiphérie de la plaquette 4 présente des demi-trous 43 analogues aux demi-trous 14 de l'embase. Les matériaux utilisés pour réaliser les plans conducteurs 41 ou 42 sont choisis de sorte qu'ils aient une conductivité électrique élevée. Selon un premier mode de fabrication, on dispose par sérigraphie des matériaux conducteurs réfractaires tels que le tungstène, le moly-manganèse ou le molybdène-tungstène sur des couches d'alumine et on procède à la cuisson de l'ensemble; selon un autre mode opératoire, on utilise un substrat d'alumine cuit sur lequel on dispose par sérigraphie des plans métalliques tels que l'argent-paladium, le cuivre, l'or ou l'or-platine, qu'on recouvre chacun d'un isolant électrique à base de verre (verre contenant de l'oxyde de plomb) et de charges cristalines telle que l'alumine. Selon un troisième processus, on utilise un empilement du type circuit imprimé multicouche, les parties isolantes étant en verre époxy par exemple ou à base de polyimide, et les parties conductrices en cuivre.

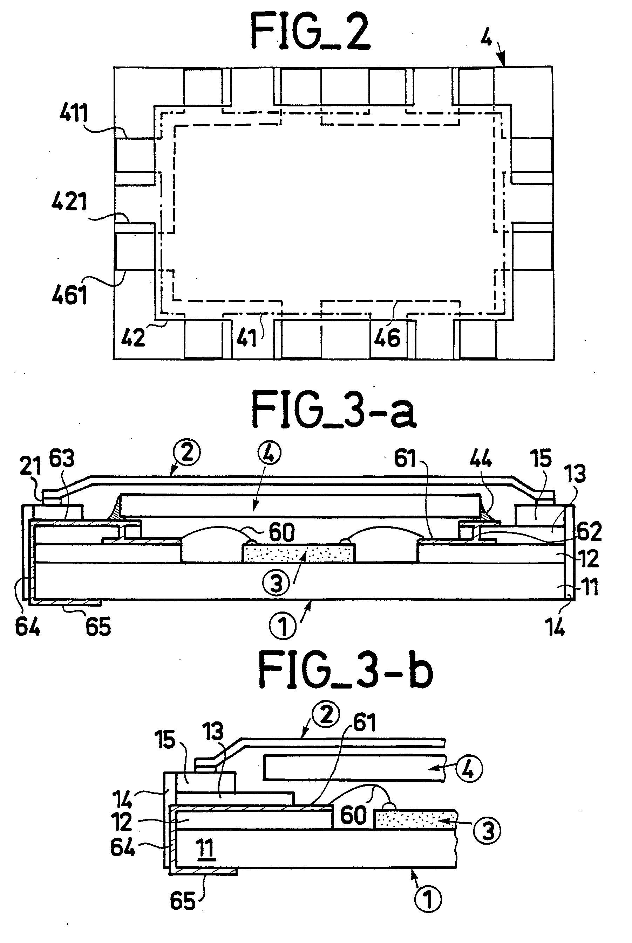

Sur la figure 2, on a représenté un exemple de disposition des différents plans conducteurs de la figure 1a. A titre d'exemple toujours, le dispositif 4 comporte trois plans conducteurs.

Sur cette figure 2, on voit que le plan conducteur 42, relié par exemple à la masse, est de dimensions légèrement inférieures à celles du dispositif 4 et se prolonge par des languettes 421 vers la périphérie du dispositif. De la même façon, le plan 41, relié par exemple à un potentiel d'alimentation, est muni de languettes 411, placées aussi près que possible des languettes de masse 421 et de préférence en nombre égal. Enfin, le plan 46, relié à un autre potentiel d'alimentation, comporte également des languettes, repérées 461 et en nombre égal aux précédentes, de façon à former des groupes de trois languettes 411, 421, 461, en nombre aussi important que nécessaire à la distribution des potentiels du dispositif 4 au composant 3.

On a ainsi réalisé une structure dans laquelle les connexions de masse et de deux potentiels d'alimentation sont distribuées sur le pourtour du dispositif 4, permettant de réduire l'inductance des entrées-sorties puisque la connexion de masse est placée entre les connexions d'alimentation, aussi proches que possible les unes des autres.

Afin de former un capot étanche pour le boîtier, le dispositif 4 est fixé (figure 1a) à l'aide d'un anneau de scellement 6 à la partie supérieure de l'embase 1. Dans l'exemple de la réalisation de la figure 1a, les connexions telles que 44 se trouvent à l'extérieur de l'anneau de scellement 6.

En outre, dans une variante de réalisation, le dispositif de répartition 4 est muni d'un ou plusieurs condensateurs discrets 5 de découplage, placés sur la figure la sur la face supérieure (extérieure) du dispositif 4; ils sont connectés entre deux plans conducteurs dont un relié à la masse, à l'aide de puits conducteurs 51 et 52, traversant l'isolant 40 et, le cas échéant, de façon isolée un ou plusieurs plans conducteurs tels que 41 ou 42, et de plots de connexion 53.

Les figures 3, a et b, représentent un deuxième mode de réalisation de l'invention dans lequel le dispsitif de répartition est situé à l'intérieur du boîtier.

Sur ces figures, on retrouve le composant 3 porté par l'embase 1 mais celle-ci est, à titre d'exemple, constituée par trois anneaux et non plus deux, déposés sur la plaquette 11, le troisième anneau étant repéré 15. Le dispositif de répartition 4 est disposé sur la face supérieure du deuxième anneau (13) et connecté comme illustré sur les figures 3a et 3b, analogues aux figures 1a et 1b. Le troisième anneau (15) est disposé à la périphérie du dispositif 4 et, reçoit un capot 2 du boîtier, fixé sur l'embase 1 par l'intermédiaire d'un joint 21. Ce capot peut être métallique ou isolant, réalisé ou non dans le même matériau que l'embase 1.

Le dispositif 4 n'a pas été détaillé sur les figures 3 (a et b) mais il est réalisé comme décrit précédemment et peut porter également des condensateurs discrets tels que 5.

Dans une variante de réalisation, le capot 2 peut également porter de tels condensateurs.

Le mode de réalisation représenté sur les figures 3 est un peu plus complexe que celui des figures 1, mais il permet de réaliser séparément les connexions du dispositif 4 et le scellement étanche du capot sur l'embase du boîtier, ce qui constitue un avantage dans certains cas de réalisation pratique.

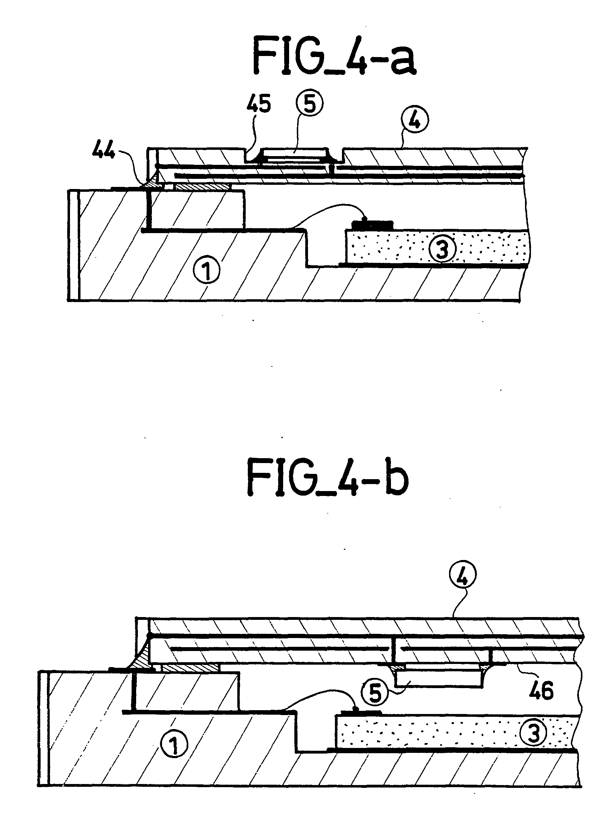

La figure 4a représente une variante dans la disposition du condensateur 5 sur le dispositif de répartition 4 des figures précédentes.

Sur cette figure, on a représenté à titre d'exemple une fraction de l'embase 1, du composant 3 et du dispositif de répartition 4, disposés les uns par rapport aux autres comme sur la figure 1a. Selon cette variante, il est pratiqué un évidement 45 dans la face extérieure du dispositif de répartition 4, évidement formant un logement dont les dimensions sont telles que le condensateur 5 puisse y être enterré et ce, sans faire saillie sur cette surface.

La figure 4b représente une autre variante de positionnement du condensateur de découplage 5.

Selon cette variante, le condensateur est placé sur la face inférieure (46) du dispositif 4 de la même façon qu'il était posé sur la face supérieure de ce même dispositif sur la figure 1a.

Selon une autre variante, non représentée, la face inférieure 46 du dispositif 4 peut présenter un évidement tel que 45 (figure 4a) pour permettre de placer le condensateur 5 sans que celui-ci dépasse le niveau de la surface.

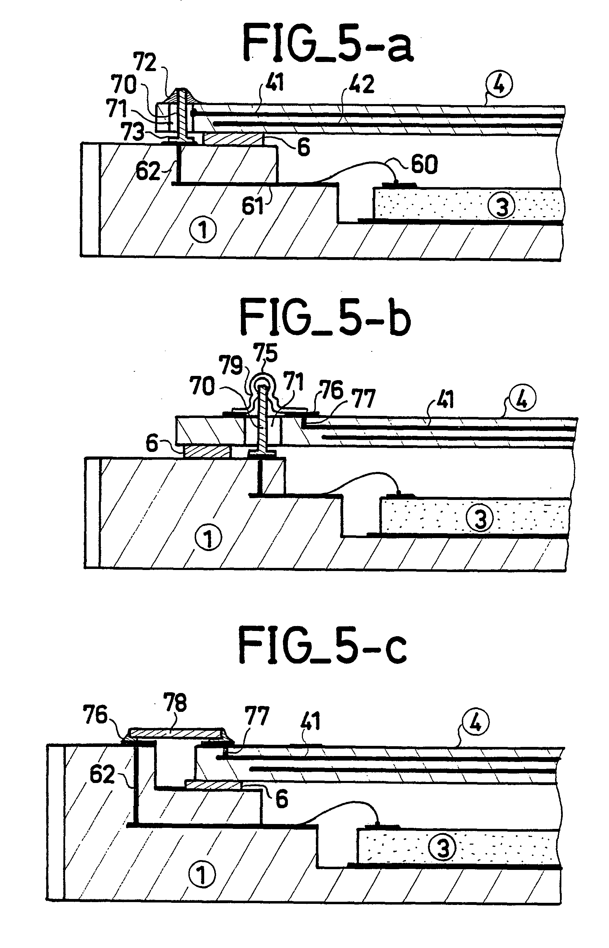

Les figures 5, a, b et c représentent différrentes variantes de la connexion du dispositif de répartition 4 au reste du boîtier.

Sur la figure 5a, on retrouve la même configuration à titre d'exemple que celle représentée sur la figure 1a (partie gauche), à savoir une embase 1 à trois étages, portant un composant 3 et un dispositif de répartition 4, connectée au composant 3 par l'intermédiaire des pistes 61, 62 et du fil de connexion 60.

Pour assurer la connexion du plan 41 par exemple à la piste 62, on dispose dans la variante de la figure 5a d'une broche de connexion 70 disposée dans un trou métallisé 71, lui-même ménagé dans le dispositif 4. Le plan conducteur 41 est en contact électrique avec le trou métallisé 71. La broche de connexion 70 est solidaire de l'embase 1 (disque 73) et soudée sur la face supérieure du dispositif 4 (soudure 72), L'anneau de scellement 6 est placé dans ce mode de réalisation à l'intérieur du boîtier par rapport à la broche 70.

Le plan conducteur 42 est connecté à un autre trou métallisé, non visible sur la figure.

La figure 5b représente une autre variante de connexion du dispositif de répartition 4 à l'embase 1.

Par rapport à la figure 5a, on trouve les différences suivantes:

la broche de connexion 70, solidaire de l'embase 1, est recouverte d'un capuchon conducteur 75 lui-même préalablement soudé ou brasé (zone 76) sur le dispositif 4;

le plan conducteur 41 est connecté en 77 à la soudure 76;

le contact électrique entre le plan 41 et la broche 70 n'est plus fait par l'intermédiaire des parois du trou 71, qui n'a donc plus besion d'être métallisé, mais par un sertissage 79 du capuchon 75 sur la broche 70;

l'anneau de scellement 6 est maintenant situé à l'extérieur du boîtier par rapport à la broche de connexion 70.

La variante de la figure 5b présente notamment l'avantage de réduire au maximum la longueur des connexions entre les éléments 3 et 4, ce qui permet de réduire l'inductance et par suite l'impédance de ces connexions; ainsi qu'il est connu, cela est particulièrement recherché dans le cas de circuits avec des potentiels bas et des temps de réponse faibles.

La figure 5c représente une autre variante de connexion du dispositif de répartition 4, dans laquelle celui-ci est posé sur la face supérieure de l'avant dernier étage de l'embase 1, par l'intermédiaire de l'anneau de scellement 6. La connexion électrique est réalisée au moyen d'un pont métallique 78, scellé ou brasé (76) d'une part sur la face supérieure du dispositif 4 et d'autre part sur la face supérieure de l'embase 1, au droit de la connexion 62. Comme sur la figure 5b, les plans de connexion 41 (par exemple) sont reliés au pont métallique par l'intermédiaire des éléments 77 et 76.

Sur les différentes variantes des figures 5, il n'a pas été représenté de condensateurs de découplage tels que 5 pour la clarté du schéma mais ceux-ci peuvent être bien entendu ajoutés selon l'une des variantes décrites plus haut.

A titre d'exemple, il a été réalisé un dispositif de répartition dans le cadre de l'exemple numérique donné plus haut, avec les dimensions suivantes: longueur et largeur égales à 24 mm, épaisseur de l'ordre de 0,5 à 1 mm pour trois plans conducteurs, l'épaisseur des plans conducteurs étant de l'ordre d'une dizaine de microns.

La description ci-dessus a été faite à titre d'exemple non limitatif: c'est ainsi notamment que les composants 5 ont été décrits comme des condensateurs discrets destinés au découplage, mais ils peuvent être consitué par tout composant, discret ou intégré, nécessaire à l'application.

## Revendications

1. Boîtier de composant électronique comportant un dispositif de répartition de potentiel électrique et une embase (1) portant le composant, caractérisé par le fait que le dispositif comporte au moins un plan conducteur (41, 42) isolé et fixé

sur l'embase, le dispositif et l'embase étant munis de moyens d'interconnexion électrique, l'embase étant munie de connexions extérieures pour relier le boîtier à au moins un potentiel électrique extérieur, et d'une pluralité de connexions intérieures pour le relier au composant, le plan conducteur étant relié par les moyens d'interconnexion avec au moins une connexion extérieure et une pluralité de connexions intérieures.

2. Boîtier selon la revendication 1, caractérisé par le fait que le dispositif comporte au moins deux plans conducteurs (41, 42), isolés (40) l'un par rapport à l'autre, et reliés à des potentiels électriques extérieurs, l'un étant un potentiel de référence et l'autre un potentiel d'alimentation pour la composant (3).

3. Boîtier selon l'une des revendications précédentes, caractérisé par le fait que le dispositif est fixé sur l'embase (1), au-dessus de la zone où le composant (3) est destiné à être fixé, de sorte qu'il constitue le capot (4) du boîtier pour le composant, le boîtier étant formé par ailleurs de l'embase.

4. Boîtier selon l'une des revendications 1 ou 2, caractérisé par le fait que le dispositif est placé sur l'embase (1), au-dessus de la zone où le composant (3) est destiné à être fixé, et recouvert d'un capot (2) fixé sur l'embase, ces deux derniers éléments formant le boîtier pour le composant.

5. Boîtier selon l'une des revendications 2 à 4, caractérisé par le fait que le dispositif comporte en outre au moins un condensateur de découplage (5) connecté entre le potentiel de référence du dispositif et le plan conducteur.

6. Boîtier selon la revendication 5, caractérisé par le fait que le condensateur (5) est placé sur l'une des faces du dispositif, en vis-à-vis ou opposée de la zone de l'embase où le composant (3) est destiné à être fixé.

7. Boîtier selon l'une des revendications 5 ou 6, caractérisé par le fait que le condensateur est placé dans un évidement (45) pratiqué sur l'une des faces du dispositif (4), de sorte qu'il ne forme pas d'excroissance sur ladite face.

8. Boîtier selon la revendication 7, caractérisé par le fait que les moyens de connexion sont de trois types, le premier type de moyens (61, 64, 65) assurant la liaison électrique du composant (3) directement avec l'extérieur et permettant de transmettre les signaux d'information, le deuxième type de moyens (63, 64, 65) assurant la liaison électrique du dispositif de répartition directement avec l'extéreiur, et permettant de transmettre au dispositif les potentiels extérieurs à répartir, et le troisième type de moyens (61, 62) assurant, à l'intérieur du boîtier, la liaison électrique du dispositif de répartition (4) avec le composant (3), permettant de transmettre à ce dernier les potentiels extérieurs.

**Patentansprüche**

1. Gehäuse for elektronische Bauelemente mit einer Vorrichtung zur Verteilung elektrischer Potentiale und einer Fußplatte (1), die die Bauelemente trägt, dadurch gekennzeichnet, daß die Vorrichtung mindestens eine isolierte und auf der Fußplatte befestigte leitende Ebene (41, 42) aufweist wobei die Vorrichtung und die Fußplatte mit Mitteln zur gegenseitigen elektrischen Verbindung und die Fußplatte mit äußeren Anschlüssen zum Anschluß des Gehäuses an mindestens ein äußeres Potential und mit einer Vielzahl von inneren Anschlüssen zur Verbindung de Fußplatte mit dem Bauelement versehen ist, wobei die leitende Ebene über die Mittel zur gegenseitigen Verbindung mit mindestens einem äußeren Anschluß und einer Vielzahl von inneren Anschlüssen verbunden ist.

2. Gehäuse nach Anspruch 1, dadurch gekennzeichnet, daß die Vorrichtung mindestens zwei gegeneinander isolierte (40) und an äußere elektrische Potentiale angeschlossene leitende Ebenen (41, 42) aufweist, wovon ein Potential ein Bezugspotential und das andere ein Versorgungspotential für das Bauelement (3) ist.

3. Gehäuse nach einem der vorhergehenden Ansprüche, dadurch gekennzeichnet, daß die Vorrichtung auf der Fußplatte (1) über der Zone befestigt ist, in der das Bauelement befestigt werden soll, derart, daß die Vorrichtung die Kappe (4) des Gehäuses für das Bauelement bildet, wobei das Gehäuse im übrigen durch die Fußplatte gebildet wird.

4. Gehäuse nach einem der Ansprüche 1 oder 2, dadurch gekennzeichnet, daß die Vorrichtung auf der Fußplatte (1) über der Zone, in der das Bauelement (3) befestigt werden soll, angeordnet und mit einer an der Fußplatte befestigten Kappe (2) abgedeckt ist, wobei diese beiden letztgenannten Bauteile das Gehäuse für das Bauelement bilden.

5. Gehäuse nach einem der Ansprüche 2 bis 4, dadurch gekennzeichnet, daß die Vorrichtung weiter mindestens einen Entkopplungskondensator (5) aufweist, der zwischen das Bezugspotential der Vorrichtung und die leitende Ebene geschaltet ist.

6. Gehäuse nach Anspruch 5, dadurch gekennzeichnet, daß der Kondensator (5) auf einer der Seiten der Vorrichtung gegenüber oder am entgegengesetzten Ende der Fußplattenzone angeordnet ist, in der das Bauelement (3) befestigt werden soll.

7. Gehäuse nach einem der Ansprüche 5 oder 6, dadurch gekennzeichnet, daß der Kondensator in einer in eine der Seiten der Vorrichtung (4) eingearbeiteten Aussparung (45) angeordnet ist derart daß er gegenüber dieser Fläche nicht hervorragt.

8. Gehäuse nach Anspruch 7, dadurch gekennzeichnet, daß die Anschlußmittel von dreierlei Art sind, wobei die erste Art der Mittel (61, 64, 65) die elektrische Verbindung des Bauelements (3) direkt mit der Außenwelt herstellt und die Übermittlung der Informationssignale ermöglicht, die zweite Art der Mittel (63, 64, 65) die elektrische Verbindung der Verteilvorrichtung direkt mit der Außenwelt herstellt und die Übermittlung der zu verteilenden Potentiale an die Vorrichtung ermöglicht, und die dritte Art der Mittel (61, 62) innerhalb des Gehäuses die elektrische Verbindung der Verteilvorrichtung (4) mit dem Bauelement (3) herstellt und die Übermittlung der äußeren Potentiale an das Bauelement ermöglicht.

## Claims

1. A casing for housing an electronic component, comprising a device adapted to distribute electric potentials and a base plate (1) carrying said component, characterized in that the device includes at least one insulated conducting layer (41, 42) fixed onto the base plate, the device and the base plate being provided with electric interconnection means, the base plate being provided with external connections for connecting the casing to at least one external electric potential, and with a plurality of internal connections for connecting the base plate with the component, the conducting layer being connected via said interconnection means to at least one external connection and to a plurality of internal connections.

2. A casing according to claim 1, characterized in that the device comprises at least two conducting layers (41, 42) insulated (40) from one another and connected to external electric potentials, one being a potential of reference and the other a feed potential for the component (3).

3. A casing according to any one of the preceding claims, characterized in that the device is fixed onto the base plate (1) above the zone wherein the component (3) is intended to be fixed, so as to constitute the cap (4) of the casing for the component, the casing being further formed by the base plate.

4. A casing according to claim 1 or 2, characterized in that the device is placed on the base plate (1) above the zone wherein the component (3) is intended to be fixed, and is covered by a cap (2) fixed onto the base plate, these two latter elements forming the casing for the component.

5. A casing according to any one of claims 2 to 4, characterized in that the device further comprises at least one discoupling capacitor (5) connected between the reference potential of the device and the conducting layer.

6. A casing according to claim 5, characterized in that the capacitor (5) is placed on one of the faces of the device, face or opposite to the zone of the base plate wherein the component (3) is intended to be fixed.

7. A casing according to claim 5 or 6, characterized in that the capacitor is placed in a recess (45) made into one of the faces of the device (4), such that the capacitor does not project from said face.

8. A casing according to claim 7, characterized in that the connection means are of three types, the first type of means (61, 64, 65) ensuring the direct electric connection between the component (3) and the exterior and allowing to transmit the information signals, the second type of means (63, 64, 65) ensuring the direct electric connection between the distribution device and the exterior and allowing to transfer to the device the electric potentials to be distributed, and the third type of means (61, 62) ensuring inside the casing the electric connection between the distribution device (4) and the component (3) and allowing to transfer the external potentials to said component.

# FIG_1-a

# FIG_1-b

EP 0 166 634 B1

# FIG_2

# FIG_3-a

# FIG_3-b

# FIG_4-a

# FIG_4-b

# FIG_5-a

# FIG_5-b

# FIG_5-c